# FASCICULE DE BREVET EUROPEEN

(11) **EP 0 972 284 B1**
(45) Date de publication et mention de la délivrance du brevet: **02.07.2003**
(21) Numéro de dépôt: 98909263.0
(22) Date de dépôt: 01.04.1998
(51) Int. Cl.: G11B 9/02, H01L 29/00, H01L 45/00, H01L 51/00, H01B 1/00, H03H 9/64

(54) **COMPOSANT ELECTRIQUE OU ELECTRONIQUE ET APPLICATION COMME MEMOIRE NON VOLATILE ET DISPOSITIF A ONDES ACOUSTIQUES DE SURFACE.**
ELEKTRISCHES ODER ELEKTRONISCHES BAUELEMENT UND SEINE VERWENDUNG ALS NICHTFLÜCHTIGER SPEICHER UND AKUSTISCHE OBERFLÄCHENWELLENVORRICHTUNG
ELECTRIC OR ELECTRONIC COMPONENT AND APPLICATION AS NON VOLATILE MEMORY AND DEVICE WITH SURFACE ACOUSTIC WAVES

(30) Priorité: 01.04.1997 FR 9704298
(43) Date de publication de la demande: 19.01.2000
(73) Titulaire: Universite de Geneve, 1211 Genève 4 (CH)
(72) Inventeur: FISCHER, Oystein, CH-1296 Coppet (CH); TRISCONE, Jean-Marc, CH-1228 Plan-les-Ouates (CH); AHN, Charles, H., CH-1205 Genève (CH); BEASLEY, Malcolm, R., Palo Alto, CA 94301 (US); RENNER, Christophe, CH-1212 Grand-Lancy (CH); TYBELL, Thomas, CH-1205 Genève (CH)
(74) Mandataire: Nithardt, Roland
(86) Numéro de dépôt international: CH9800123
(87) Numéro de publication internationale: WO98044498

(56) Documents cités:
- EP-A- 0 275 881
- WO-A-93/21637
- US-A- 2 922 986
- US-A- 3 170 083
- US-A- 4 389 445
- US-A- 4 410 823
- US-A- 4 731 754
- US-A- 5 168 420
- US-A- 5 206 525
- US-A- 5 216 631
- US-A- 5 371 729
- US-A- 5 384 797
- US-A- 5 472 935
- US-A- 5 481 527
- US-A- 5 732 177
- PATENT ABSTRACTS OF JAPAN vol. 006, no. 092 (P-119), 29 mai 1982 & JP 57 027447 A (TOSHIBA CORP), 13 février 1982,
- PATENT ABSTRACTS OF JAPAN vol. 006, no. 088 (P-118), 26 mai 1982 & JP 57 024044 A (TOSHIBA CORP), 8 février 1982,
- PATENT ABSTRACTS OF JAPAN vol. 096, no. 004, 30 avril 1996 & JP 07 335772 A (HITACHI LTD), 22 décembre 1995,

## Description

La présente invention concerne un circuit électrique ou électronique comportant une structure composite comprenant au moins une couche d'un matériau ferroélectrique, au moins un semi-conducteur ou un film mince d'un métal ou d'un supraconducteur, en contact intime avec au moins une première face de ladite couche de matériau ferroélectrique et des moyens pour générer des modifications locales de la polarisation de ladite couche de matériau ferroélectrique.

Elle concerne également l'application de ce circuit comme dispositif à onde acoustique de surface.

Elle concerne également un circuit électrique ou électronique et l'application de ce circuit comme dispositif à onde acoustique de surface et comme mémoire non volatile.

Au cours de la dernière décennie, de rapides progrès ont été faits dans le domaine du dépôt de films de structures composites épitaxiales à base d'oxydes, qui sont par exemple à l'origine de progrès conséquents dans le domaine des supraconducteurs en oxyde de cuivre et qui ont permis de préparer des films épitaxiaux de matériaux tels que les oxydes de manganèse magnétorésistifs. L'une des nombreuses autres familles de matériaux qui ont été réalisés récemment par cette approche épitaxiale sont les oxydes ferroélectriques. L'une des caractéristiques attractives de ces matériaux est leur champ de polarisation réversible non volatile. D'autre part, on a développé de nombreux dispositifs à effet de champ électrique qui vont des mémoires dynamiques à accès aléatoire (DRAMs) à des nanosystèmes modèles tels que les gaz électroniques à deux dimensions.

Tous ces dispositifs nécessitent l'utilisation d'électrodes métalliques permanentes pour produire et maintenir le champ électrique, ce qui constitue un inconvénient majeur parce que leur fabrication implique un travail de lithographie important et délicat pour la réalisation des électrodes métalliques.

Le brevet US-5 206 525 décrit un dispositif qui est sensiblement équivalent à un transistor à effet de champ dont le diélectrique est remplacé par un matériau macromoléculaire pi-conjugué mélangé à un matériau ferro-électrique. Le but consiste à modifier la conductivité par le champ électrique. Ce dispositif ne permet pas de modifier localement les propriétés électroniques.

Le brevet US 5 371 729 décrit un dispositif de stockage de données basé sur une commutation locale de la polarisation d'un film ferroélectrique déposé sur un semi-conducteur. Le but de l'invention est d'augmenter la vitesse de travail par utilisation de tensions élevées qui génèrent un phénomène d'avalanche.

L'abrégé de la demande JP 07 335772 a pour objet un dispositif à onde acoustique de surface permettant de lire un état de mémoire ferro-électrique. Cette invention permet d'obtenir une lecture non destructrice de la mémoire.

La demande de brevet européen publiée sous le N° EP-0 275 881 décrit un dispositif qui utilise un microscope à effet tunnel pour écrire et lire des informations sur un film électriquement polarisé, principalement en polymère. Ce dispositif n'est pas prévu pour inscrire des informations au moyen d'impulsions de courant et pour lire ces informations par la détection de modifications locales de la densité électronique.

Le brevet US 5 168 420 est un brevet sur l'épitaxie d'oxydes ferroélectriques sur des supraconducteurs pour une application dans le stockage d'informations. Dans ce document il n'est pas question d'une quelconque modification des propriétés électroniques des matériaux.

Le brevet US 3 170 083 décrit l'utilisation d'un faisceau électronique pour contrôler la polarisation d'un matériau ferroélectrique et permettre le stockage d'informations dans un dispositif de mémoire, mais ne permet pas d'obtenir une modification des propriétés électroniques du matériau.

Le brevet US 2 922 986 décrit également une méthode de stockage d'informations dans un dispositif de mémoire basée sur la polarisation ferroélectrique sans modification des propriétés électroniques du matériau, la lecture de ces informations se faisant de manière pyroélectrique.

Le brevet US 4 410 823 décrit la possibilité d'utiliser les parois de domaines ferroélectriques comme réflecteurs d'ondes acoustiques de surface. Cette utilisation est limitée à la technique standard des dispositifs à onde acoustique de surface.

Le but de la présente invention est de proposer un nouveau circuit électrique ou électronique complexe sans contact électrique permanent en exploitant l'effet de champ ferroélectrique qui provoque une modification locale des propriétés électroniques, et dans lequel les procédures lithographiques, qui sont habituellement nécessaires pour sa réalisation, deviennent plus simples ou totalement superflues. En outre la fabrication de ce circuit est non invasive.

Ce but est atteint par le circuit selon l'invention, caractérisé en ce qu'il comporte des moyens pour générer une déformation locale de ladite couche de matériau ferroélectrique en vue de générer une onde acoustique de surface se basant sur lesdites modifications locales de la polarisation.

Selon un mode de réalisation préféré, lesdits moyens pour générer des modifications locales de polarisation de la couche de matériau ferroélectrique comportent un dispositif pour appliquer une tension entre au moins une électrode ponctuelle, agencée pour balayer de manière sélective une deuxième face de ladite structure composite opposée à celle constituée par le semi-conducteur ou film mince de métal ou de supraconducteur, et ledit semi-conducteur ou film mince de métal ou de supraconducteur.

Ce but est également atteint par le circuit électrique ou électronique, caractérisé en ce qu'il comporte une structure composite comprenant au moins une couche d'un matériau ferroélectrique, au moins un semi-conducteur ou un film mince de métal ou de supraconducteur en contact intime avec une première face de ladite couche de matériau ferroélectrique et un film très mince semi-conducteur ou métallique ou supraconducteur, ce dernier étant en contact intime avec une deuxième face de la couche de matériau ferroélectrique, opposée à la première face, ainsi que des moyens pour générer des modifications locales de la polarisation de ladite couche de matériau ferroélectrique soit pour modifier localement, à l'échelle allant du nanomètre au micromètre, la densité électronique d'une zone dudit semi-conducteur ou du film mince de métal ou de supraconducteur, cette zone étant proche de ladite première face de ladite couche de matériau ferroélectrique, soit pour créer une déformation locale de ladite couche de matériau ferroélectrique en vue de générer une onde acoustique de surface.

Selon un mode de réalisation avantageux, lesdits moyens pour générer des modifications locales de polarisation de la couche de matériau ferroélectrique comportent un dispositif pour appliquer une tension entre au moins une électrode ponctuelle, agencée pour balayer de manière sélective ladite deuxième face de ladite structure composite portant le film très mince semi-conducteur ou métallique ou supraconducteur, et en ce qu'une tension est appliquée entre l'électrode ponctuelle et ledit film très mince.

Dans une variante de réalisation, une tension est appliquée entre l'électrode ponctuelle et le semi-conducteur ou le film mince de métal ou de supraconducteur en contact intime avec la première face de ladite couche de matériau ferroélectrique.

Dans une autre variante de réalisation, une tension est appliquée entre le semi-conducteur ou le film mince de métal ou de supraconducteur et le film très mince semi-conducteur, métallique ou supraconducteur.

D'une manière particulièrement avantageuse, l'état de polarisation de ladite couche de matériau ferroélectrique est représenté par une caractéristique sensible à des modifications locales de la densité électronique dudit semi-conducteur, ou du film mince d'un métal ou d'un supraconducteur.

Dune manière préférentielle, ladite caractéristique est la conductance tunnel entre une électrode ponctuelle balayant la deuxième face de ladite structure composite opposée à celle constituée par le semi-conducteur ou film mince de métal ou de supraconducteur, et ledit semi-conducteur ou film très mince de métal ou de supraconducteur.

De façon avantageuse, ladite électrode ponctuelle est constituée par une pointe d'un microscope à sonde locale. Ils peuvent également être constitués par une source de particules.

Selon deux modes de réalisation, ladite source de particules peut être agencée pour générer un faisceau électronique ou un faisceau ionique.

Dans une variante de réalisation, les moyens pour générer des modifications locales de polarisation sont constitués par une source de rayonnement.

Une des applications particulièrement avantageuses du circuit est la réalisation d'un dispositif à onde acoustique de surface.

Une autre application avantageuse du circuit est la réalisation d'une mémoire non volatile.

La présente invention sera mieux comprise à la lecture de la description d'une forme de réalisation préférée du circuit selon l'invention et de ses variantes et en référence aux dessins dans lesquels:
les figures 1 et 2 représentent des vues schématiques en perspective illustrant deux modes de réalisation du circuit électrique ou électronique selon l'invention, et
la figure 3 représente l'application du circuit comme dispositif à ondes acoustiques de surface.

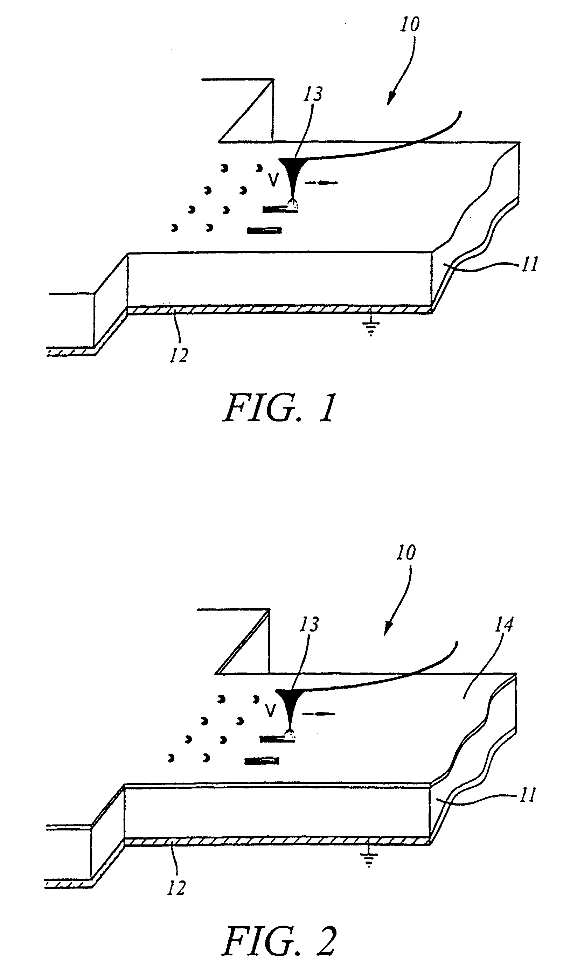

Le circuit selon l'invention tel que représenté par la figure 1 comporte principalement une structure composite 10 comprenant une couche d'un matériau ferroélectrique 11, sous la forme d'un film, et un semi-conducteur ou un film en métal ou en supraconducteur 12, qui est en contact intime avec une des faces de la couche de matériau ferroélectrique 11. Par ailleurs, le circuit comporte des moyens pour générer des modifications locales de la polarisation de ladite couche de matériau ferroélectrique 11. L'objectif recherché est de modifier localement la densité électronique d'une zone dudit semi-conducteur ou dudit film mince de métal ou de supraconducteur 12 proche de la face de la couche de matériau ferroélectrique 11, ou de créer une déformation locale de la couche de matériau ferroélectrique en vue de générer une onde acoustique de surface.

Ces moyens comportent un dispositif pour appliquer une tension entre ledit semi-conducteur ou film mince en métal ou en supraconducteur 12 et au moins une électrode ponctuelle 13 agencée pour balayer de manière sélective la face de ladite couche de matériau ferroélectrique 11, opposée à la face portant le film mince 12. Cette électrode ponctuelle est constituée par exemple par une pointe d'un microscope à sonde locale. Elle peut également être constituée par une source de particules. Cette source de particules peut être agencée pour générer un faisceau électronique ou un faisceau ionique. Elle peut également être une source de rayonnement.

Une application particulièrement avantageuse de l'invention est un circuit électrique écrit à l'échelle du nanomètre avec la pointe d'un microscope à sonde locale servant d'électrode ponctuelle ou une source de particules permettant de réaliser une modification locale de la polarisation du matériau ferroélectrique. La polarisation (±) du matériau de la couche ferroélectrique modifie la densité électronique du métal ou du semi-conducteur proche de la surface et cette modification définit le circuit électrique.

Dans ce but, dans un premier contexte idéal, un microscope à force atomique (AFM) comportant une pointe conductrice balaie la surface de la structure composite, dite hétérostructure épitaxiale ferroélectrique, composée dans ce èas des matériaux suivants : Pb(ZrO.52 TiO.48)O3 (PZT)/SrRuO3 pendant qu'une tension est appliquée entre la pointe et le semi-conducteur ou le film de métal ou de supraconducteur. Lorsque le champ électrique entre la pointe et le film conducteur est plus grand que le champ coercitif de la couche de matériau ferroélectrique 11, la polarisation de cette couche bascule localement sous la pointe et induit un flux de charges d'écran dans la couche de métal ou de semi-conducteur modifiant ainsi la densité totale de porteurs et donc la résistivité du conducteur, qui peut être mesurée avec les techniques standards de mesures de transports électroniques. Dans le contexte idéal, le semi-conducteur ou le film mince métallique ou supraconducteur a une faible densité de porteurs et une caractéristique électrique ou électronique qui est sensible à des changements de densité d'état électronique.

Selon une deuxième forme de réalisation avantageuse, représentée par la figure 2, la structure 10 est complétée par un matériau semi-conducteur, métallique ou supraconducteur 14 déposé sur la deuxième face de la couche de matériau ferroélectrique 11 opposée au film mince 12. Ce matériau se présente avantageusement sous la forme d'un film très mince qui est en contact intime avec le matériau ferroélectrique 11. II peut avoir la forme d'un film continu ou celle d'îlots. Ce film constitue à la fois un moyen pour appliquer une tension sur la couche de matériau ferroélectrique 11 en combinaison avec le film mince 12 et un moyen de passivation de la surface du matériau ferroélectrique polarisé.

Les moyens pour générer des modifications locales de la polarisation comportent un dispositif pour appliquer une tension entre au moins une électrode ponctuelle 13, agencée pour balayer de manière sélective la couche de matériau ferroélectrique 11 ou le film 14, et ledit film très mince 14 ou ledit film mince 12. On peut également appliquer simultanément une tension entre ledit film très mince 14 et ledit film mince 12. La polarisation du matériau ferroélectrique peut être obtenue en appliquant des impulsions de tension sur l'électrode ponctuelle et éventuellement en présence d'une tension à travers la couche de matériau ferroélectrique d'une valeur inférieure à sa tension coercitive.

Ce circuit permet d'établir un effet de champ local d'une manière non invasive, permettant ainsi de créer des nanostructures électroniques sans contacts électriques réalisés par les procédés lithographiques habituels. L'intérêt de l'invention est qu'elle offre une approche et des perspectives complètement nouvelles pour la fabrication de dispositifs à effet de champ et de petites structures électroniques. Le basculement de domaines avec un microscope de proximité dans la direction verticale produisant un contraste électronique non susceptible de passivation est particulièrement avantageux.

L'avantage principal de cette approche est qu'elle permet d'écrire directement des structures électroniques submicroniques sans substitution chimique et sans procédé lithographique et/ou électrodes permanentes. L'effet de champ est local, réversible, non volatil, et non invasif. Cette technique présente un autre avantage, elle permet d'avoir un mécanisme de détection pour la lecture/écriture de domaines ferroélectriques qui n'est pas sensible à une détérioration du contraste due à une passivation électrostatique. De ce fait, cette forme de réalisation du circuit peut être utilisée comme mémoire non volatile.

Dans la pratique, toute sonde locale qui permet de basculer la polarisation d'un matériau ferroélectrique peut être utilisée. Par exemple un microscope à effet tunnel peut être utilisé pour polariser ce matériau ferroélectrique, si ce dernier est recouvert d'une couche conductrice suffisamment mince. Ce microscope à effet tunnel peut également être utilisé pour mesurer et lire les changements dans la densité de porteurs produits par le champ électrique, par exemple en mesurant les modifications dans la conductance tunnel (densités d'états).

Pour la lecture de petits domaines ferroélectriques, d'autres mécanismes de contraste peuvent être envisagés qui se basent sur les propriétés piézo-électriques et pyroélectriques des ferroélectriques. De manière similaire à ce qui a été décrit plus haut, ces approches ne seraient également pas susceptibles à une passivation.

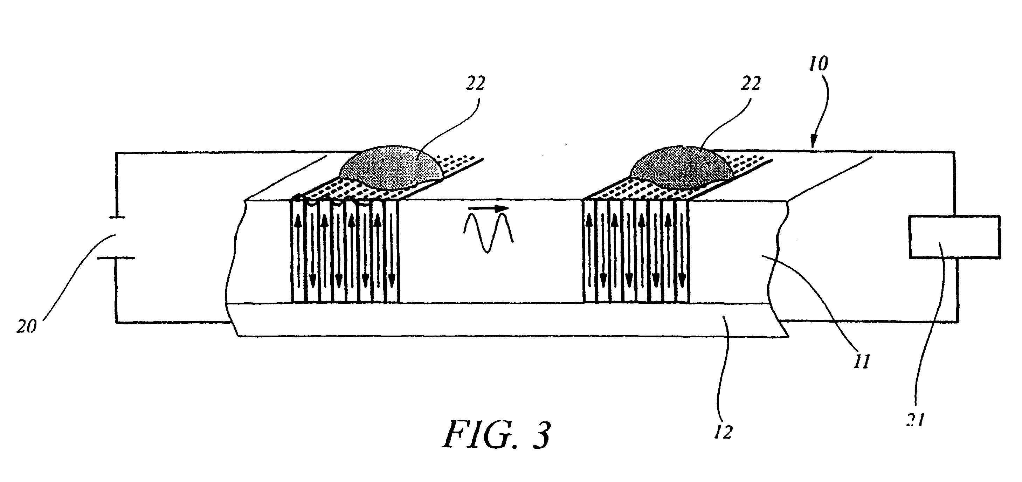

La figure 3 illustre schématiquement une application du circuit défini ci-dessus 20 comme dispositif à onde acoustique de surface. La structure composite 10 comporte dans ce cas, par exemple une couche d'un matériau ferroélectrique 11 ayant été polarisé localement, par exemple périodiquement, et un semi-conducteur ou un film mince d'un métal ou d'un supraconducteur 12. Un signal alternatif provoque, par effet piézo-électrique, une déformation dont le signe dépend de la polarisation et excite une onde acoustique de surface si la fréquence de ce signal est égale à la vitesse de l'onde de surface divisée par la longueur d'onde.

Dans les dispositifs connus, les limitations induites par les techniques 30 lithographiques engendrent des limitations de fréquence au voisinage de 1 GHz.

Deux contacts 22 à la surface de la structure composite 10 permettent de générer et de détecter respectivement au moyen d'un dispositif d'excitation 20 et d'un détecteur 21 de fréquences allant jusqu'à 20 GHz et plus.

Le dispositif a une résolution spatiale très élevée, ce qui permet d'atteindre ces fréquences élevées qui ne peuvent pas être atteintes avec des dispositifs classiques à contacts déposés par des procédés lithographiques.

## Revendications

1. Circuit électrique ou électronique comportant une structure composite (10) comprenant au moins une couche d'un matériau ferroélectrique (11), au moins un semi-conducteur ou un film mince d'un métal ou d'un supraconducteur (12), en contact intime avec au moins une première face de ladite couche de matériau ferroélectrique (11) et des moyens (13) pour générer des modifications locales de la polarisation de ladite couche de matériau ferroélectrique (11), **caractérisé en ce qu'**il comporte des moyens (20, 22) pour générer une déformation locale de ladite couche de matériau ferroélectrique (11) en vue de générer une onde acoustique de surface se basant sur lesdites modifications locales de la polarisation.

2. Circuit selon la revendication 1, **caractérisé en ce que** lesdits moyens pour générer des modifications locales de polarisation de la couche de matériau ferroélectrique (11) comportent un dispositif pour appliquer une tension entre au moins une électrode ponctuelle (13), agencée pour balayer de manière sélective une deuxième face de ladite structure composite (10) opposée à celle constituée par le semi-conducteur ou film mince de métal ou de supraconducteur (12), et ledit semi-conducteur ou film mince de métal ou de supraconducteur (12).

3. Circuit électrique ou électronique, **caractérisé en ce qu'**il comporte une structure composite (10) comprenant au moins une couche d'un matériau ferroélectrique (11), au moins un semi-conducteur ou un film mince de métal ou de supraconducteur (12) en contact intime avec une première face de ladite couche de matériau ferroélectrique (11) et un film très mince semi-conducteur ou métallique ou supraconducteur (14), ce dernier étant en contact intime avec une deuxième face de la couche (11) de matériau ferroélectrique, opposée à la première face, ainsi que des moyens (13) pour générer des modifications locales de la polarisation de ladite couche de matériau ferroélectrique (11) soit pour modifier localement, à l'échelle allant du nanomètre au micromètre, la densité électronique d'une zone dudit semi-conducteur ou du film mince de métal ou de supraconducteur (12), cette zone étant proche de ladite première face de ladite couche de matériau ferroélectrique (11), soit pour créer une déformation locale de ladite couche de matériau ferroélectrique (11) en vue de générer une onde acoustique de surface.

4. Circuit selon la revendication 3, **caractérisé en ce que** lesdits moyens pour générer des modifications locales de polarisation de la couche de matériau ferroélectrique (11) comportent un dispositif pour appliquer une tension entre au moins une électrode ponctuelle (13), agencée pour balayer de manière sélective ladite deuxième face de ladite structure composite (10) portant le film très mince semi-conducteur ou métallique ou supraconducteur (14), et **en ce qu'**une tension est appliquée entre l'électrode ponctuelle (13) et ledit film très mince (14).

5. Circuit selon les revendications 3 et 4, **caractérisé en ce qu'**une tension est appliquée entre l'électrode ponctuelle (13) et le semi-conducteur ou le film mince de métal ou de supraconducteur (12) en contact intime avec la première face de ladite couche de matériau ferroélectrique (11).

6. Circuit selon la revendication 3, **caractérisé en ce qu'**une tension est appliquée entre le semi-conducteur ou le film mince de métal ou de supraconducteur (12) et le film très mince semi-conducteur, métallique ou supraconducteur (14).

7. Circuit selon la revendication 3, **caractérisé en ce que** l'état de polarisation de ladite couche de matériau ferroélectrique (11) est représenté par une caractéristique sensible à des modifications locales de la densité électronique dudit semi-conducteur, ou du film mince d'un métal ou d'un supraconducteur (12).

8. Circuit selon la revendication 7, **caractérisé en ce que** ladite caractéristique est la conductance tunnel entre une électrode ponctuelle (13) balayant la deuxième face de ladite structure composite (10) opposée à celle constituée par le semi-conducteur ou film mince de métal ou de supraconducteur (12), et ledit semi-conducteur ou film très mince de métal ou de supraconducteur (14).

9. Circuit selon les revendications 2 et 4, **caractérisé en ce que** ladite électrode ponctuelle est constituée par une pointe d'un microscope à sonde locale.

10. Circuit selon les revendications 1 et 3, **caractérisé en ce que** lesdits moyens pour générer des modifications locales de la polarisation sont constitués par une source de particules.

11. Circuit selon la revendication 10, **caractérisé en ce que** ladite source de particules est agencée pour générer un faisceau électronique.

12. Circuit selon la revendication 10, **caractérisé en ce que** ladite source de particules est agencée pour générer un faisceau ionique.

13. Circuit selon les revendications 1 et 3, **caractérisé en ce que** lesdits moyens pour générer des modifications locales de la polarisation sont constitués par une source de rayonnement.

14. Application du circuit selon l'une quelconque des revendications précédentes comme dispositif à onde acoustique de surface.

15. Application du circuit selon l'une quelconque des revendications 3 à 13 comme mémoire non volatile.

## Patentansprüche

1. Elektrischer oder elektronischer Schaltkreis mit einer Verbundstruktur (10), die mindestens eine aus einem ferroelektrischen Material bestehende Schicht (11), mindestens einen Halbleiter oder einen dünnen Film (12) aus einem Metall- oder einem Supraleiter, der mit mindestens einer ersten Fläche der Schicht (11) aus ferroelektrischem Material in intensivem Kontakt steht, und Einrichtungen (13) zum Erzeugen örtlicher Polarisationsveränderungen der Schicht (11) aus ferroelektrischem Material aufweist,
**dadurch gekennzeichnet, dass**
er Einrichtungen (20,22) zum Erzeugen einer örtlichen Verformung der Schicht (11) aus ferroelektrischem Material aufweist, um eine auf den örtlichen Polarisationsveränderungen basierende Oberflächenschallwelle zu erzeugen.

2. Schaltkreis nach Anspruch 1,
**dadurch gekennzeichnet, dass**
die Einrichtungen zum Erzeugen der örtlichen Polarisationsveränderungen der Schicht (11) aus ferroelek-trischem Material eine Vorrichtung zum Anlegen einer Spannung zwischen mindestens einer Punktelektrode (13), die zum selektiven Abtasten einer zweiten Fläche der Verbundstruktur (10) in der Lage ist, die der aus dem Halbleiter oder dünnen Metall- oder Supraleiterfilm (12) bestehenden gegenüberliegt, und dem Halbleiter oder dünnen Metall- oder Supraleiterfilm (12) aufweisen.

3. Elektrischer oder elektronischer Schaltkreis,
**dadurch gekennzeichnet, dass**
er eine Verbundstruktur (10) aufweist, die mindestens eine aus einem ferroelektrischen Material bestehende Schicht (11), mindestens einen Halbleiter oder einen dünnen Metall- oder Supraleiterfilm (12), der mit einer ersten Fläche der Schicht (11) aus ferroelektrischem Material in intensivem Kontakt steht, und einen sehr dünnen Halbleiter- oder Metall- oder Supraleiterfilm (14) aufweist, wobei der letztere mit einer der ersten Fläche gegenüberliegenden zweiten Fläche der Schicht (11) aus ferroelektrischem Material in intensivem Kontakt steht, sowie Einrichtungen (13) zum Erzeugen örtlicher Polarisationsveränderungen der Schicht (11) aus ferroelektrischem Material, entweder zur örtlichen Veränderung der elektronischen Dichte einer Zone des Halbleiters oder des dünnen Metall- oder Supraleiterfilms (12) vom Nanometer- zum Mikrometer-Messbereich aufweist, wobei die Zone in der Nähe der ersten Fläche der Schicht (11) aus ferroelektrischem Material liegt, oder zum Erzeugen einer örtlichen Verformung der Schicht (11) aus ferroelektrischem Material aufweist, um eine Oberflächenschallwelle zu erzeugen.

4. Schaltkreis nach Anspruch 3,
**dadurch gekennzeichnet, dass**
die Einrichtungen zum Erzeugen der örtlichen Polarisationsveränderungen der Schicht (11) aus ferroelektrischem Material eine Vorrichtung zum Anlegen einer Spannung zwischen mindestens einer Punktelektrode (13), die zum selektiven Abtasten der zweiten Fläche der Verbundstruktur (10) in der Lage ist, die den sehr dünnen Halbleiter- oder Metall- oder Supraleiterfilm (14) trägt, aufweisen, und eine Spannung zwischen der Punktelektrode (13) und dem sehr dünnen Film (14) angelegt wird.

5. Schaltkreis nach den Ansprüchen 3 und 4,
**dadurch gekennzeichnet, dass**
eine Spannung zwischen der Punktelektrode (13) und dem mit der ersten Fläche der Schicht (11) aus ferroelektrischem Material in intensivem Kontakt stehenden dünnen Metall- oder Supraleiterfilm (12) angelegt wird.

6. Schaltkreis nach Anspruch 3,
**dadurch gekennzeichnet, dass**
eine Spannung zwischen dem Halbleiter oder dem dünnen Metall- oder Supraleiterfilm (12) und dem sehr dünnen Halbleiter-, Metall- oder Supraleiterfilm (14) angelegt wird.

7. Schaltkreis nach Anspruch 3,
**dadurch gekennzeichnet, dass**
die Schicht (11) aus ferroelektrischem Material durch ein für örtliche Veränderungen der elektronischen Dichte des Halbleiters oder des dünnen Films (12) aus einem Metall oder einem Supraleiter empfindliches Merkmal dargestellt wird.

8. Schaltkreis nach Anspruch 7,
**dadurch gekennzeichnet, dass**
das Merkmal der Tunnelleitwert zwischen einer Punktelektrode (13), die die zweite Fläche der Verbundstruktur (10) abtastet, die der aus dem Halbleiter oder dünnen Metall- oder Supraleiterfilm (12) bestehenden gegenüberliegt, und dem Halbleiter oder sehr dünnen Metall- oder Supraleiterfilm (12) ist.

9. Schaltkreis nach den Ansprüchen 2 und 4,
**dadurch gekennzeichnet, dass**
die Punktelektrode aus einer Spitze eines Punktsondenmikroskops besteht.

10. Schaltkreis nach den Ansprüchen 1 und 3,
**dadurch gekennzeichnet, dass**
die Einrichtungen zum Erzeugen örtlicher Polarisationsveränderungen aus einer Teilchenquelle bestehen.

11. Schaltkreis nach Anspruch 10,
**dadurch gekennzeichnet, dass**
die Teilchenquelle zum Erzeugen eines Elektronenstrahls in der Lage ist.

12. Schaltkreis nach Anspruch 10,
**dadurch gekennzeichnet, dass**
die Teilchenquelle zum Erzeugen eines Ionenstrahls in der Lage ist.

13. Schaltkreis nach den Ansprüchen 1 und 3,
**dadurch gekennzeichnet, dass**
die Einrichtungen zum Erzeugen örtlicher Polarisationsveränderungen aus einer Strahlenquelle bestehen.

14. Anwendung des Schaltkreises nach einem der vorangegangenen Ansprüche als Oberflächenschallwellenvorrichtung.

15. Anwendung des Schaltkreises nach einem der Ansprüche 3 bis 13 als nicht flüchtiger Speicher.

## Claims

1. An electric or electronic circuit comprising a composite structure (10) consisting of at least one layer of a ferroelectric material (11), at least one semiconductor or a thin film of metal or superconductor material (12), in close contact with at least a first surface of said layer of ferroelectric material (11), and means (13) for generating local modifications in the polarization of said layer of ferroelectric material (11), **characterized in that** it comprises means (20, 22) for generating a local deformation in said layer of ferroelectric material (11) in order to generate an acoustic surface wave based on said local modifications in the polarization.

2. The circuit according to claim 1, **characterized in that** said means for generating local modifications in the polarization of the ferroelectric layer (11) consists of a device for applying current between at least one selective electrode (13), designed to selectively scan a second surface of said composite structure (10) opposite the surface consisting of the semi-conductor or the thin film of metal or superconductor material (12), and said semi-conductor or thin film of metal or superconductor material (12).

3. An electric or electronic circuit, **characterized in that** it comprises a composite structure (10) comprising at least one layer of ferroelectric material (11), at least one semi-conductor, or a thin film of metal or superconductor material (12) in close contact with a first surface of said layer of ferroelectric material (11) and a very thin film of semi-conductor or metal or superconductor material (14), this latter being in close contact with a second surface of the layer (11) of ferroelectric material, which is opposite the first surface, as well as a means (13) for generating local modifications in the polarization of said layer of ferroelectric material (11), in order to either locally modify, on a scale ranging from manometer to micrometer, the electronic density of one zone of said semi-conductor or thin film of metal or superconductor material (12), this zone being near said first surface of said layer of ferroelectric material (11), or to create a local deformation in said layer of ferroelectric material (11) in order to generate an acoustic surface wave.

4. The circuit according to claim 3, **characterized in that** said means for generating local modifications in the polarization of the layer of ferroelectric material (11) consists of a device for applying current between at least one selective electrode (13), designed to selectively scan said second surface of said composite structure (10) supporting the very thin film of semiconductor or metal or superconductor material (14), and **in that** current is applied between the selective electrode (13) and said very thin film (14).

5. The circuit according to claims 3 and 4, **characterized in that** current is applied between the selective electrode (13) and the semi-conductor or the thin film of metal or superconductor material (12) in close contact with the first surface of said layer of ferroelectric material (11).

6. The circuit according to claim 3, **characterized in that** current is applied between the semiconductor or the thin film of metal or superconductor material (12) and the very thin film of semiconductor, metal, or superconductor material (14).

7. The circuit according to claim 3, **characterized in that** the state of the polarization of said layer of ferroelectric material (11) is shown by a characteristic sensitive to local modifications in the electronic density of said semi-conductor, or said thin film of metal or superconductor material (12).

8. The circuit according to claim 7, **characterized in that** said characteristic is the tunnel conductance between a selective electrode (13) scanning the second surface of said composite structure (10) opposite the surface consisting of the semi-conductor or the thin film of metal or superconductor material (12), and said semi-conductor or very thin film of metal or superconductor material (14).

9. The circuit according to claims 2 and 4, **characterized in that** said selective electrode consists of the tip of a microscope with a local sensor.

10. The circuit according to claims 1 and 3, **characterized in that** said means for generating local modifications in the polarization consists of a particle source.

11. The circuit according to claim 10, **characterized in that** said particle source is designed to generate an electron beam.

12. The circuit according to claim 10, **characterized in that** said particle source is designed to generate an ion beam.

13. The circuit according to claims 1 and 3, **characterized in that** said means for generating local modifications in the polarization consists of a radiation source.

14. An application of the circuit according to anyone of the preceding claims as an acoustic surface wave device.

15. An application of the circuit according to anyone of claims 3 to 13 as a non-volatile memory.
